# FASCICULE DE BREVET EUROPEEN

(11) **EP 2 264 742 B1**
(45) Date de publication et mention de la délivrance du brevet: **01.02.2012**
(21) Numéro de dépôt: 10162051.6
(22) Date de dépôt: 05.05.2010
(51) Int. Cl.: H01L 21/18

(54) **Procédé de transfert d'une couche mince sur un substrat cible ayant un coefficient de dilatation thermique différent de celui de la couche mince**
Transferverfahren einer Dünnschicht auf ein Zielsubstrat, das einen anderen Wärmedehnungskoeffizienten besitzt als die Dünnschicht
Method for transferring a thin layer to a target substrate having a different thermal expansion coefficient to that of the thin layer

(30) Priorité: 18.06.2009 FR 0954126
(43) Date de publication de la demande: 22.12.2010
(73) Titulaire: Commissariat à l'Énergie Atomique et aux Énergies Alternatives, 75015 Paris (FR)
(72) Inventeur: Fournel, Franck, 38190, Villard-Bonnot (FR)
(74) Mandataire: Colombo, Michel

(56) Documents cités:
- FR-A1- 2 848 337
- FR-A1- 2 888 400
- US-B1- 6 251 754
- GOMES S R ET AL: "Preparation of silica-based hybrid materials by gamma irradiation" NUCLEAR INSTRUMENTS & METHODS IN PHYSICS RESEARCH, SECTION - B:BEAM INTERACTIONS WITH MATERIALS AND ATOMS, ELSEVIER, AMSTERDAM, NL, vol. 248, no. 2, 1 août 2006 (2006-08-01), pages 291-296, XP024957783 ISSN: 0168-583X [extrait le 2006-08-01]

## Description

### Domaine de l'invention

L'invention concerne le transfert d'une couche mince depuis un substrat-source sur un substrat-cible ayant un coefficient de dilatation thermique sensiblement différent de celui du substrat-source.

Un procédé classique pour procéder à un tel transfert de couche est connu sous la désignation de « Smart Cut™ » ; il consiste principalement à réaliser les étapes suivantes (voir notamment le document FR - 2 681 472 ou son équivalent US - 5 374 564, ainsi que ses divers développements et perfectionnements) :
- création par implantation ionique d'une zone fragilisée enterrée au sein du substrat-source, délimitant avec la surface libre la future couche mince à transférer,
- assemblage du substrat source avec le substrat cible au niveau de ladite surface libre, et
- apport d'énergie thermique et/ou mécanique pour provoquer une fracture au sein du substrat-source, au niveau de la zone fragilisée.

Lors de la fabrication, par ce procédé « Smart Cut™ », d'une hétérostructure (c'est-à-dire d'une structure composée d'au moins deux matériaux différents, généralement en plusieurs couches, et ayant une épaisseur comprise typiquement entre 1µm et 1cm), le contrôle des contraintes internes est très important lorsque les différents matériaux de l'hétérostructure ont des coefficients de dilatation thermique sensiblement différents alors que l'on souhaite induire la fracture à une température sensiblement différente de celle à laquelle le collage a été réalisé (par exemple lorsqu'on désire utiliser un traitement thermique pour induire tout ou partie de la fracture de la zone fragilisée).

En effet, dans le cas, par exemple, du transfert d'un film de silicium depuis un substrat source (dont au moins une partie superficielle est en silicium) sur un substrat cible dont le coefficient de dilatation thermique est très différent de celui du substrat source silicium (par exemple, un substrat cible en silice fondue), les deux substrats massifs sont classiquement collés, par exemple par collage moléculaire, à température ambiante. Lorsqu'on choisit, pour transférer le film, d'utiliser un apport d'énergie thermique, il est connu que l'on consolide alors l'interface de collage ; toutefois ce traitement thermique a aussi pour effet que des contraintes internes, pouvant être très importantes, sont générées en conséquence de la différence de coefficients de dilatation de part et d'autre de cette interface de collage ; il en découle que, lorsque le transfert du film de silicium s'effectue (c'est-à-dire lorsque survient la fracture induite par le procédé « Smart Cut™ »), les deux substrats (ou une partie des deux substrats si la fracture ne s'est pas étendue sur toute la surface des substrats) sont brutalement séparés et ils se relaxent alors immédiatement. Ce saut de contrainte, s'il est trop important, risque d'endommager l'une ou l'autre des deux parties de l'hétérostructure ainsi séparées (formées, dans l'exemple ici considéré, par le substrat de silice portant la couche mince de silicium transférée) et le substrat de silicium dans lequel la fracture a été provoquée).

On comprend aisément l'intérêt qu'il y aurait à être capable de minimiser le saut de contrainte qui apparaît lors de la séparation d'une hétérostructure à une température différente de sa température de création.

### Etat de l'art

Pour minimiser un tel saut de contraintes, on peut penser à créer l'hétérostructure à chaud, de préférence au moins approximativement à la température à laquelle on voudra ensuite provoquer la fracture. Toutefois, lorsque l'hétérostructure est obtenue par collage moléculaire, l'énergie de ce collage diminue de façon importante lorsque l'on colle au dessus de 200°C, alors qu'il s'agit d'une température basse à laquelle l'application de la technologie « Smart Cut™ » peut se révéler difficile, par simple apport d'énergie thermique, dans un système silicium/silice fondue par exemple (pour transférer un film de silicium sur le substrat de silice fondue) ; il en découle que, lorsque l'on souhaite provoquer une fracture par seul apport thermique on souhaite en pratique procéder à une température bien supérieure à 200°C. Or, si l'énergie de collage est trop faible, les contraintes d'origine thermique peuvent être suffisantes pour provoquer un décollement de la structure au niveau de l'interface (au lieu de la zone fragilisée) ou au moins conduire à un mauvais fonctionnement de la technologie « Smart Cut™ » : en effet, l'interface de collage peut alors ne pas supporter pas la pression verticale imposée par le développement des microcavités engendrées par ce procédé [voir à ce propos « Silicon on insulator material technology » de M. Bruel, Electron. Lett. Vol 31-N°14 (1995) p.1201].

Pour minimiser le saut de contraintes il a déjà été proposé de procéder au collage des parties de l'hétérostructure dans des conditions telles que le régime de contraintes, au niveau de l'interface, devienne inférieur à un seuil donné lorsque cette hétérostructure est amenée à la température à laquelle on voudra procéder à la fracture, au niveau d'une zone fragilisée dans l'une des plaquettes auprès de l'interface de collage. Ainsi, le document FR-2 848 336, ou son équivalent US - 2006/0205179, ou FR 2848337 propose de realiser le collage de deux plaquettes ayant subi une déformation préalable. Plus précisément, ce document enseigne d'imposer une contrainte aux plaquettes au moment du collage à température ambiante, en courbant les deux plaques avant le collage moléculaire ; si la courbure est judicieusement choisie, il est possible de minimiser voire d'annuler les contraintes internes générées par le recuit thermique de l'hétérostructure à la température de fracture. Mais, pour permettre des séparations par « Smart Cut™ » lors de recuits thermiques de courte durée, ce procédé demande en général de coller les structure avec des rayons de courbures assez importants ce qui, technologiquement, peut se révéler assez délicat à réaliser à l'échelle industrielle ; en outre, les conditions de la future fracture doivent être connues au moment où on procède au collage. Par contre, cette technologie présente l'avantage que le collage moléculaire peut être effectué à température ambiante et permet donc d'avoir une bonne énergie de collage au moment du transfert.

Il en découle qu'ainsi il est possible d'obtenir le transfert d'une couche mince, à une température aussi haute qu'on le souhaite, à partir de l'une des plaquettes vers l'autre des plaquettes, la fracture se produisant au niveau de la zone fragilisée préalablement formée, tandis que l'interface de collage entre cette couche mince et la plaquette à laquelle elle est désormais fixée peut avoir une haute énergie de collage. Il faut toutefois noter que, lors du retour à une température ambiante, la couche mince peut être mise sous contrainte, en traction ou en compression, du fait de sa différence de coefficient de dilatation thermique vis-à-vis de la plaquette elle est solidement fixée par le collage moléculaire ; en effet, puisque la plaquette cible est en pratique plus massive que la couche mince, elle ne se déforme guère lors du changement de température après la fracture, imposant à la couche mince son changement dimensionnel du fait du changement de température.

Un tel phénomène avait déjà été mis à profit, dans le cas d'une homostructure (c'est-à-dire une structure formée de couches ou substrats en un même matériau); en effet, Feijoo et al avaient proposé d'imposer, à température ambiante, une contrainte au sein d'une homostructure par l'application d'une déformation juste avant la formation par collage de cette homostructure (voir D. Feijoo, I. Ong, K. Mitani, W. S. Yang, S. Yu and U. M. Gösele, "Prestressing of bonded wafers", Proceedings of the 1 st international symposium on semiconductor wafer bonding, Science, Technology and applications, Vol. 92-7, The Electrochemical Society (1992) p.230). Plus précisément, dans cet article scientifique, une homostructure est constituée de deux plaques de silicium qui sont collées avec un certain rayon de courbure (il est mentionné que, lors de la déformation, les plaques se collent et se décollent plusieurs fois). Les auteurs proposent ensuite d'amincir à température ambiante un des cristaux de silicium par des moyens mécaniques (rodage) pour pouvoir imposer une contrainte importante dans le film de silicium aminci, après retour de l'autre piaque à une forme plane.

II est à noter que ce document n'envisage pas que la couche mince solt obtenue par une fracture au sein de l'une des plaques de l'homostructure ; a fortiori, ce document n'aborde en aucune manière le problème de la séparation d'une hétérostructure à une température différente de la température de création (en effet, il n'y aurait pas de problème particulier à propos d'une homostructure, puisqu'il n'y a pas d'effet thermique sur l'état de contraintes à l'interface).

Un objet de l'invention est de minimiser le saut de contraintes entre deux substrats lors du transfert d'une couche mince de l'un de ces substrats vers l'autre, par fracture d'une zone préalablement fragilisée, même par Simple apport d'énergie thermique, à une température quelconque, sans avoir à prévoir une mise sous contraintes par déformation au moment du collage entre ces deux substrats. On comprend en effet tout intérêt qu'il peut y avoir à pourvoir procéder à l'assemblage par collage, à une température quelconque, par exemple à l'ambiante (donc sans avoir à sacrifier le niveau d'énergie de collage), sans avoir à imposer de déformation préalable, donc par exemple à plat tout simplement, et sans avoir à connaître à l'avance les conditions de la future fracture réalisant le transfert.

De l'état de la technique est également connu de: FR2888400A1, et US6251754B1

### Solution proposée par l'invention

L'invention, propose à cet effet un procédé de transfert d'une couche mince conforme à la revendication 1.

II est à noter que l'invention minimise le saut de contraintes qui a lieu lors de la fracture le long de la zone fragilisée, sans pour autant chercher à minimiser les contraintes à l'intérieur de l'hétérostructure ; en effet, contrairement à la solution antérieure qui visait à minimiser le régime de contraintes de part et d'autre de zone fragilisée au moment de la fracture, l'invention vise à générer des contraintes qui sont sensiblement les même avant et après la fracture: il n'y a donc pas de variation brusque de contraintes lors de la fracture : or ce sont les variations brusques de contraintes, et non pas la valeur absolue de ces contraintes, qui sont susceptibles de provoquer des dégradations des couches de l'hétérostructure.

Selon des caractéristiques préférées de l'invention, éventuellement combinées :
- ledit empilement est réalisé d'une manière telle que chacune des deux parties situées de part et d'autre de l'interface comporte un plan de symétrie parallèle à ladite interface,
- ledit empilement est uniquement formé de couches formées de l'un ou l'autre des premier et second matériaux,
- l'une des parties de l'empilement comporte une couche du premier matériau prise entre deux autres couches du second matériau ayant des épaisseurs sensiblement égales, en ayant une épaisseur sensiblement égale au double des épaisseurs de ces autres couches, tandis que l'autre des parties de l'empilement comporte une couche du second matériau prise entre deux autres couches formées du premier matériau ayant des épaisseurs sensiblement égales, en ayant une épaisseur sensiblement égale au double des épaisseurs de ces autres couches,

- la première partie comporte une double couche du premier matériau prise en sandwich entre deux couches identiques du second matériau, tandis que l'autre partie comporte une double couche du second matériau prise en sandwich entre deux couches identiques du premier matériau,
- après la fracture le long de la zone fragilisée, on provoque un détachement au niveau d'une interface de collage au sein de la partie à laquelle la couche mince a été transférée,
- le détachement est provoqué au niveau d'un interface formé, au sein de l'assemblage, avec une énergie de collage réduite ; il peut être noté que le fait que ce détachement ne se fait pas du coté du film transféré a pour intérêt qu'il n'y a pas de risque d'endommagement (contrairement au transfert mécanique...).
- l'on utilise la partie de l'empilement dont la couche mince a été séparée au sein d'un nouvel empilement après avoir formée une nouvelle zone fragilisée délimitant avec la surface libre libérée par la fracture, une future couche mince,
- la zone fragilisée est formée par implantation ionique,
- le premier matériau est du silicium.

### Description de l'invention

Des objets, caractéristiques et avantages de l'invention ressortent de la description qui suit, donnée à titre d'exemple illustratif non limitatif en regard des dessins annexés sur lesquels :
- la figure 1 est un schéma représentant un empilement conforme à l'invention, selon un premier mode de réalisation,
- la figure 2 est un schéma représentant un autre empilement conforme à l'invention, selon un second mode de réalisation,
- la figure 3 est un graphique représentant les évolutions, en fonction de la température avant puis après la fracture, des contraintes au sein des couches de la partie de l'empilement de la figure 1, au-dessus de la zone fragilisée,
- la figure 4 est un graphique représentant les évolutions, en fonction de la température avant puis après la fracture, des contraintes au sein des couches de la partie de l'empilement de la figure 1, en dessous de la zone fragilisée,
- la figure 5 est un graphique représentant les évolutions, en fonction de la température avant et après la fracture, des contraintes de part et d'autre du substrat-source surmonté par un substrat-cible vers lequel une couche mince du substrat-source doit être transféré, et
- la figure 6 est un graphique représentant les évolutions, en fonction de la température avant et après la fracture, des contraintes de part et d'autre du substrat-cible vers lequel la couche mince de la figure 5 doit être transférée.

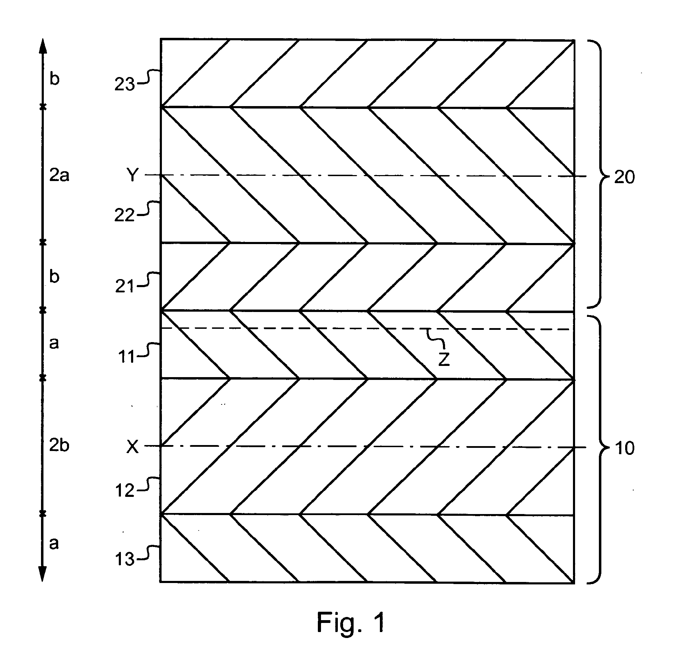

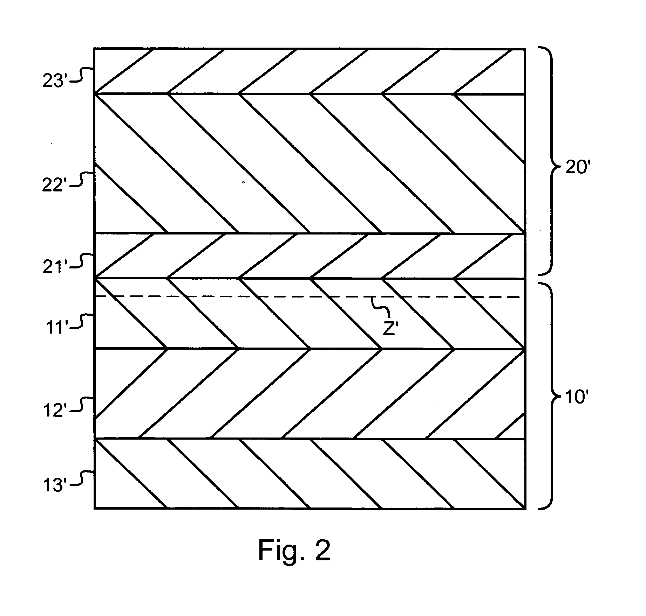

Les figures 1 et 2 représentent deux exemples d'empilements permettant, selon l'invention, de procéder de manière fiable au transfert, par apport d'énergie au moins en partie thermique, d'une couche mince depuis un substrat-cible vers un substrat-source, même lorsque ces substrats ont des coefficients de dilatation thermique sensiblement différents.

On comprend en effet que, lorsque deux couches de matériaux différente sont collées l'une à l'autre puis font l'objet d'un apport thermique, cet apport thermique génère, au niveau de l'interface de collage et parallèlement à celui-ci, une mise en traction des couches superficielles de la couche dont le coefficient de dilatation thermique est le plus faible et une mise en compression des couches superficielles de l'autre couche dont le coefficient de dilatation thermique le plus élevé (la couche qui se dilate le plus tend à allonger celle qui se dilate le moins, et cette dernière tend à empêcher la couche l'allongement naturel de cette couche qui se dilate le plus).

Ainsi que le montrent ces deux exemples de réalisation, l'invention vise à permettre un transfert d'une couche mince d'une première couche en un premier matériau vers une autre couche en un second matériau, ces premier et second matériaux ayant des coefficients de dilatation thermique sensiblement différents, et ces couches étant situées en une position médiane de l'empilement considéré. Ces empilements sont conçus, non pas pour minimiser les contraintes existant le long des surfaces libérées par la fracture au niveau d'une zone fragilisée au sein de la première couche, mais pour réduire les variations, au moment de la fracture, des contraintes existant localement de part et d'autre de cette zone fragilisée. En d'autres termes, l'invention vise à réduire les sauts de contraintes intervenant au moment de la fracture, tout en admettant l'existence ce ces contraintes à un niveau non négligeable.

Ces empilements sont réalisés à une température quelconque par rapport à la température à laquelle on prévoit de provoquer la fracture ; le plus simple est de procéder à la température ambiante. En outre, il n'y aucune précontrainte volontairement appliquée aux couches de cet empilement au moment de leur assemblage par collage. Puisque les couches sont en pratiques planes, l'assemblage est en pratique réalisé à plat.

Dans l'exemple de la figure 1, l'objectif est de transférer une couche mince depuis une couche source 11 en un matériau A vers une couche cible 21 en un matériau B. Chacune de ces couches comporte une surface libre et le transfert de la couche mince de l'une à l'autre de ces couches est prévu après que ces couches ont été mises en contact intime par leurs surfaces libres respectives. Ces couches ont une épaisseur d'au moins 50 microns, de préférence au moins 100 microns (ce ne sont donc pas de fines couches, mais des couches communément appelées « couches épaisses »).

Préalablement, une couche fragilisée notée Z a été réalisée à une distance choisie sous la surface par laquelle la couche 11 est ensuite mise en contact intime avec une surface de la couche 21. Cette couche fragilisée est typiquement réalisée par implantation (en pratique par bombardement ionique) d'une ou plusieurs espèces, notamment une implantation d'hydrogène, d'hélium, voire d'autres gaz ou même d'éléments plus lourds. La distance choisie entre la surface libre de la couche-cible et la zone fragilisée est en pratique au plus égale à 1/100^{ème} de l'épaisseur de cette couche ; de préférence, la future couche mince (délimitée entre cette surface et cette zone fragilisée) a une épaisseur d'au plus 1/1000^{ème} de celle de la couche. La figure 1 ne respecte pas ce rapport, pour des raisons évidentes de lisibilité.

La couche 11 peut n'être qu'une couche superficielle d'un substrat-source formé d'au moins une autre couche sous-jacente ; de même, la couche 21 peut n'être qu'une couche superficielle d'un substrat-cible formé d'au moins une autre couche supérieure.

Selon l'invention, avant l'étape de séparation au cours de laquelle on prévoit de provoquer la fracture au niveau de la couche fragilisée Z, on assemble le substrat-source et le substrat-cible, par leurs surfaces libres, au sein d"un empilement de couches alternées formées du premier ou du second matériau tel que, de part et d'autre de l'interface formé par la mise en contact intime des surfaces libres :
- il y a des épaisseurs cumulées de couches formées du premier matériau qui sont sensiblement égales,
- il y a des épaisseurs cumulées de couches formées du second matériau qui sont sensiblement égales.

De manière avantageuse, cet empilement est tel que chacune des deux parties de l'empilement situées de part et d'autre de l'interface entre les couches 11 et 21 admet un plan de symétrie, schématisé par les lignes mixtes X-X et Y-Y.

Il peut y avoir des couches intermédiaires de faible épaisseur entre les diverses couches en matériau A ou en matériau B, mais de préférence, l'empilement est uniquement formé de couches formées de l'un ou de l'autre de ces matériaux A et B (s'il y a des couches intermédiaires d'accrochage, leur épaisseur cumulée ne représente pas plus de 1% de l'épaisseur totale de l'empilement.

Plus précisément, il ressort de l'examen de la figure 1 que l'empilement est formé :
- d'une partie inférieure 10 formée de la couche 11 en matériau A, surmontant une couche 12 en matériau B, surmontant une couche 13 en matériau A, la couche 12 ayant une épaisseur double de celle de la couche 11 et la couche 13 ayant la même épaisseur que la couche 11,
- d'une partie supérieure formée 20 formée de la couche 21 en matériau B, surmontée d'une couche 22 en matériau A, elle-même surmontée d'une couche 23 formée du matériau B, l'épaisseur de la couche 22 étant le double de celle de la couche 21 et la couche 23 ayant la même épaisseur que cette couche 21.

De la sorte, la couche 11 dont on veut séparer une couche mince vers la couche 21 est prise en sandwich entre des couches (12 et 21) en matériau B, tandis que la couche 21 est, elle aussi, prise en sandwich entre des couches (11 et 22). Il en découle que, lors d'une variation de température après l'assemblage, chacune des couches 11 et 21 est sollicitée de manière analogue le long de ses faces inférieure et supérieure, d'où un champ de contraintes approximativement homogène.

Il en découle que, lors d'un traitement thermique appliqué après un assemblage avantageusement réalisé à la température ambiante, les contraintes existant dans la couche 11 de part et d'autre de la zone fragilisée Z sont voisines, de sorte que la fracture n'implique pas, au sein des deux parties de la couche 11 séparées par la fracture, de saut de contraintes important au point d'être susceptible de provoquer une dégradation de l'une de ces parties.

On peut montrer que, si l'on utilise les calculs de mécanique développés par Z-C Feng et al. (Zhe-Chuan Feng and Hong-du Liu J; Appl. Phys. 54(1), 1983, p.83 "Generalized formula for curvature radius and layer stresses caused by thermal strain in semiconductor multilayer structures."), on peut prédire les contraintes qui vont apparaître au sein des couches de l'empilement 10+20 (formant une hétérostructure), avant et après la séparation par fracture le long de la zone fragilisée.

On peut noter que l'empilement peut être considéré comme étant formé d'un empilement de quatre paires de couches A-B (à partir du bas, on peut en effet décrire l'empilement de la figure 1 comme étant la succession d'une paire A-B, d'une paire B-A, d'une paire B-A puis d'une paire A-B).

Dans l'empilement de la figure 1 les couches 11 et 21 (et donc les couches 13 et 23) ont des épaisseurs égales a=b, tandis que les couches 12 et 22 ont des épaisseurs égales 2a=2b ; en prenant la décomposition en paires A-B, cela correspond à des paires de couches de même épaisseur et l'empilement peut se représenter comme étant l'assemblage d'un sous-empilement inférieur ABBA et d'un empilement supérieur BAAB, et la fracture au niveau de la couche fragilisée aboutit à la formation d'un ensemble inférieur ABBA' et d'un ensemble supérieur aBAAB (A' représentant ce qui reste de la couche 11 après séparation de la couche mince notée « a »).

Toutefois, l'invention s'applique aussi au cas de couches ayant des épaisseurs différentes, ainsi que le schématise la figure 2 où l'épaisseur b vaut 2/3 de l'épaisseur a. En désignant les couches par les mêmes signes de référence qu'à la figure 1, avec l'addition de l'indice « prime », on constate que la couche intermédiaire 22' supérieure a une épaisseur qui vaut 3 fois l'épaisseur de la couche 21' ou 23', tandis que la couche intermédiaire 12' a une épaisseur à peine supérieure à celle de la couche 11' ou 13'.

Les calculs précités permettent toutefois de vérifier que, même avec une telle différence, on obtient des champs de contraintes permettant une fracture sans sauts de contraintes importants au moment de la fracture.

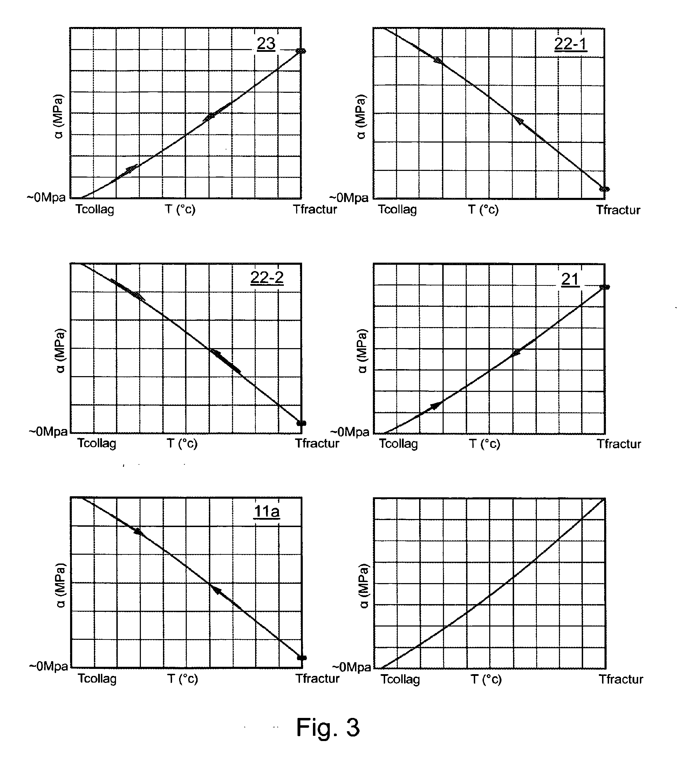

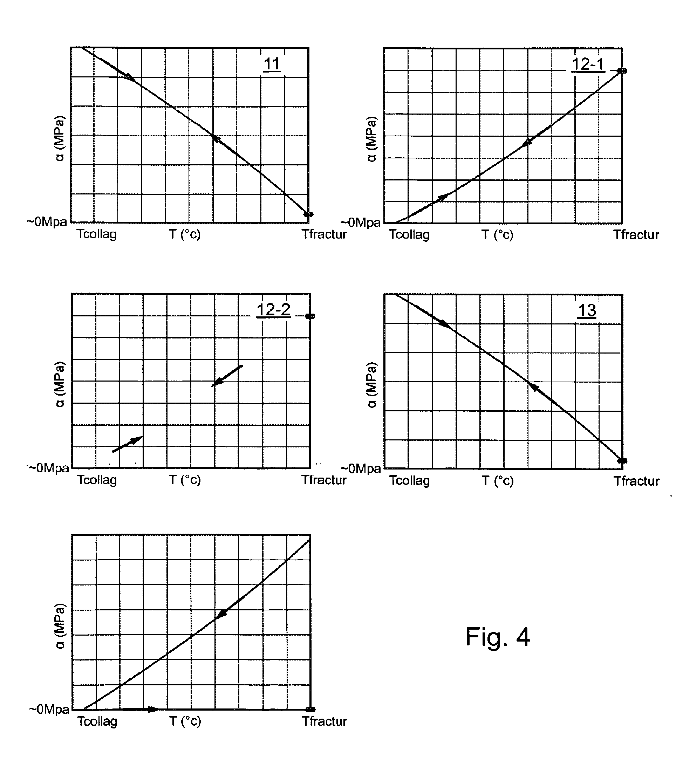

Les figures 3 et 4 représentent les courbes de variation de la contrainte au sein des diverses couches, après assemblage à la température ambiante, lors de la montée en température pour un traitement thermique de fracture (la fracture est schématisée par un astérisque en bord droit des cadres de ces courbes), puis lors du retour à la température ambiante.

Plus précisément, la figure 3 regroupe les courbes correspondant à chacune des couches de la partie supérieure de l'empilement de la figure 1, à partir du haut, dans le cas où la couche intermédiaire 22 est elle-même formée de deux couches identiques, notées 22-1 et 22-2, et avec la couche mince transférée qui est notée 11 a.

Quant à la figure 4, elle regroupe les courbes correspondant à chacune des couches de la partie inférieure de l'empilement de la figure 1, à partir de la couche 11, dans le cas où la couche intermédiaire 12 est elle-même formée de deux couches identiques, notées 12-1 et 12-2.

Ces courbes sont calculées dans le cas suivant :
- les couches 11, 13, 22-1 et 22-2 sont en silicium et ont des épaisseurs égales à 750 microns,
- les couches 21, 23 et 12-1 et 12-2 sont en silice fondue, et ont des épaisseurs de 1200 microns.

On observe que, puisque le silicium se dilate plus que la silice fondue, une montée en température génère, parallèlement à l'interface entre les couches, une mise en traction de la silice par le silicium et donc une mise en compression de la silice par le silicium ; en d'autres termes les couches de silice sont le siège de contraintes positives, donc de traction, le long de courbes bien définies et similaires au sein des couches 23, 21, 12-1 et 12-2 ; par contre, les couches de silicium sont le siège de contraintes négatives, donc de compression, le long de courbes bien définies et similaires au sein des couches 22-1, 22-2, 11 a, 11 et 13.

Les flèches dirigées vers la droite décrivent le sens de parcours des courbes lors d'une augmentation de température, tandis que les flèches dirigées vers la gauche décrivent le sens de parcours des mêmes courbes lors d'un refroidissement ; on observe que les mêmes courbes sont parcourues dans le sens de l'échauffement et lors du refroidissement bien qu'il y ait une fracture à la température maximale avec la séparation de la structure en deux sous-structures.

En fait, les contraintes ne sont pas exactement identiques à l'intérieur des couches puisque l'on prélève un film d'un des substrats, ce qui déséquilibre très légèrement les deux sous-structures, de sorte qu'il y a un léger saut de contrainte lors de la fracture de la zone fragilisée de la couche 11 ; mais, dans l'exemple considéré d'une alternance de couches de silicium et de silice et une couche mince d'épaisseur inférieure au 1/1000^{ème} de l'épaisseur des couches de silicium et de silice, le saut n'est que de l'ordre de 0.1 MPa, ce qui ne génère pas de dégradation au sein des couches (y compris au sein de la couche mince) lors de la fracture. Ce saut influe aussi légèrement l'évolution de la flèche de chaque structure, mais celle-ci évolue très peu (moins de 0.5 micron).

Il est intéressant de noter que les couches de l'empilement restent sensiblement planes lors des variations de température, y compris lors de la fracture, ce qui facilite la manipulation des couches, prises isolément ou en combinaison (au fur et à mesure de leur assemblage), pendant ces traitements thermiques.

Ainsi que cela a été mentionné plus haut, le substrat-source peut être constitué par la couche 11 seule, ou être formée des couches 11 et 12-1, voire des couches 11 et 12 ou même des couches 11, 12 et 13. De même, le substrat-cible peut être constitué de la seule couche 21, ou des couches 21 et 22-2, voire des couches 21 et 22, ou encore des couches 21, 22 et 23. On comprend que dans chacun de ces cas, il est possible de réaliser, en ajoutant éventuellement des couches, l'empilement de la figure 1 (ou celui de la figure 2) en fonction des épaisseurs relatives des couches.

Dans le cas où, après la fracture de transfert, on souhaite récupérer le substrat-cible avec la couche transférée, il est utile de pouvoir détacher la (ou les) couche(s) qui a (ont) été ajoutée(s) à ce substrat-cible pour la formation de l'empilement.

Pour ce faire, on assemble avantageusement ce substrat-cible de départ, à la couche adjacente nécessaire pour former l'empilement voulu, en donnant à l'interface de collage une énergie de collage réduite, par exemple en rugosifiant l'une et/ou l'autre des surfaces ainsi assemblées. En conséquence, après refroidissement de l'ensemble 11a-21-22-23 obtenu après la fracture, un détachement au niveau de l'interface à énergie réduite peut être obtenu facilement, par exemple in insérant une lame dans l'interface à libérer ; il est à noter que, si cela se fait effectivement à la température ambiante, il n'y a pas de saut de contraintes au moment de ce détachement. Si par contre, on choisit de réaliser un tel détachement à une température différente de l'ambiante (donc à une température différente de celle à laquelle l'empilement a été réalisé), l'éventuel saut de contrainte généré n'aura pas de conséquence sensible sur la couche mince puisque cet éventuel saut de contrainte aura lieu au niveau d'une face du substrat-cible qui est à l'opposé de la couche mince transférée. Il peut être noté que, puisque le collage à faible énergie est réalisé à distance de la zone fragilisée, la rupture peut être efficacement localisée au niveau de cette zone fragilisée, dès lors que le collage à faible énergie est toutefois suffisant pour résister aux contraintes globales générées au niveau des diverses interfaces lors du traitement thermique.

En fait, un détachement au niveau de l'interface de collage précité peut être contrôlable dans de bonnes conditions même si l'on ne prévoit pas de dégrader l'énergie de collage, puisqu'un détachement mécanique reste possible jusqu'à des énergies de collage importantes telles que 0.5 J/m².

Quant à la partie basse de l'empilement, comportant le substrat-source, elle peut être directement réutilisée, pour transférer une nouvelle couche mince à partir de la couche 11, en la recollant, après un nouveau traitement de fragilisation, sur un substrat-cible analogue à celui de départ, en le complétant par la partie de l'empilement qui a été détachée au niveau de collage précité.

Ainsi que cela a été mentionné également, il est possible que l'accrochage entre couches formées des matériaux A et B soit facilité par l'interposition de couches d'accrochage. Ce qui précède reste tout à fait valable tant que l'épaisseur cumulée des couches intermédiaires non formées de A ou de B reste inférieure à de l'ordre de 0.1% de l'épaisseur de la couche considérée.

On comprend que les avantages de l'invention sont conservés lorsqu'on souhaite provoquer la fracture par application, en complément d'un traitement thermique, d'une énergie de nature mécanique (fluide ou lame, ou vibrations, ultrasons).

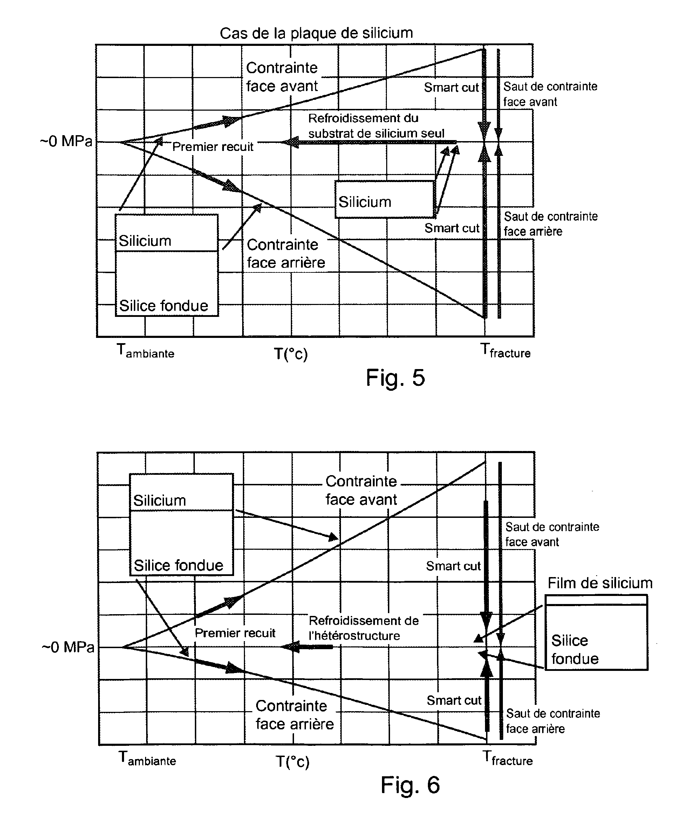

Les figures 5 et 6 représentent, à titre de comparaison, les courbes représentant les variations des contraintes le long des faces opposées d'une couche source et d'une couche cible similaires aux seules couches 11 et 21 précitées, en l'absence des couches additionnelles 12 et 13, d'une part et 22 et 23, d'autre part.

On comprend aisément que les avantages de l'invention peuvent s'obtenir même si l'on s'écarte légèrement des conditions dimensionnelles précitées ; c'est ainsi qu'on conserve certains de ces avantages jusqu'à des écarts de quelques 20% des épaisseurs recommandées.

### Exemple de réalisation

On met en oeuvre des couches de silicium et de silice fondue.

On prépare quatre substrats de silicium et quatre substrats de silice fondue en préparant les deux surfaces de chaque substrat pour un collage moléculaire. Les deux faces d'un des substrats de silicium sont rugosifiées par traitement chimique de 20 mn avec du SC1 (solution H2O/H2O2/NH4OH, dans des proportions relatives 5-1-1) à 70 °C. La face arrière de ce substrat est ensuite repolie pour ne pas avoir d'énergie de collage dégradée en face arrière.

Un autre substrat de silicium est implanté avec des ions hydrogène avec une dose de 6.1016 at/cm² à une énergie de 76 keV. On construit ensuite par collages moléculaires successifs, un empilement B-A-A(rugueux)-B-A(implanté)-B-B-A.

On appliquer un traitement de recuit à 500°C pendant une heure, ce qui provoque la séparation de l'ensemble en deux structures, respectivement B-A-A(rugueux)-B-a(film de A) et A(moins la couche mince)-B-B-A.

On détache ensuite B-a (produit final souhaité) en insérant une lame au niveau de l'interface de collage préalablement rugosifié de A(rugueux) et B-a.

Les courbes des figures 3 et 4 correspondent aux calculs correspondant à l'exemple décrit ci-dessus, en prenant :
- module d'Young du silicium : 130 GPa
- module d'Yong de la silice : 70 GPa
- coefficient de Poisson du silicium : 0.3
- coefficient de Poisson de la silice : 0.17,
- épaisseur de chaque couche de silicium : 750 microns
- épaisseur de chaque couche de silice : 1200 microns
- coefficient de dilatation thermique de la silice : 0.55.10-6
- coefficient de dilatation thermique de Si : variation selon une courbe croissante à concavité vers le bas et la droite, entre 2.4 10⁻⁶ et 4.2 10⁻⁶, comme indiqué dans la littérature.

## Revendications

1. Procédé de transfert d'une couche mince depuis un substrat-source dont une couche superficielle longeant une surface libre est en un premier matériau, vers un substrat-cible dont au moins une couche superficielle longeant une surface libre est en un second matériau ayant un coefficient de dilatation thermique différent de celui du premier matériau, selon lequel :
* on forme au sein de la couche superficielle du substrat-source une zone fragilisée délimitant avec une surface libre une future couche mince,
* on assemble le substrat-source, par sa surface libre, à la surface libre du substrat-cible, au sein d'un empilement de couches alternées formées des premier et second matériaux tel qu'il y a, de chaque côté de l'interface formée par l'assemblage desdites surfaces libres mises en contact intime, des couches des premier et second matériaux, l'épaisseur cumulée des couches du premier matériau situées d'un premier côté de cette interface étant égale à l'épaisseur cumulée des couches de ce premier matériau situées de l'autre côté de cette interface et l'épaisseur cumulée des couches du second matériau situées de ce premier côté de l'interface étant égale à l'épaisseur cumulée des couches de ce second matériau situées de l'autre côté de cette interface, les couches ayant des épaisseurs au moins égales à 50 microns et au moins égales à 1000 fois la profondeur à laquelle la zone fragilisée est formée,
* on provoque, par apport d'énergie au moins en partie thermique, une fracture le long de la zone fragilisée en sorte de détacher la couche mince.

2. Procédé selon la revendication 1, **caractérisé en ce que** ledit empilement est réalisé d'une manière telle que chacune des deux parties situées de part et d'autre de l'interface comporte un plan de symétrie parallèle à ladite interface.

3. Procédé selon la revendication 1 ou la revendication 2, **caractérisé en ce que** ledit empilement est uniquement formé de couches formées de l'un ou l'autre des premier et second matériaux.

4. Procédé selon l'une quelconque des revendications 1 à 3, **caractérisé en ce que** l'une des parties de l'empilement comporte une couche du premier matériau prise entre deux autres couches du second matériau ayant des épaisseurs sensiblement égales, en ayant une épaisseur sensiblement égale au double des épaisseurs de ces autres couches, tandis que l'autre des parties de l'empilement comporte une couche du second matériau prise entre deux autres couches formées du premier matériau ayant des épaisseurs sensiblement égales, en ayant une épaisseur sensiblement égale au double des épaisseurs de ces autres couches.

5. Procédé selon la revendication 4, **caractérisé en ce que** la première partie comporte une double couche du premier matériau prise en sandwich entre deux couches identiques du second matériau, tandis que l'autre partie comporte une double couche du second matériau prise en sandwich entre deux couches identiques du premier matériau.

6. Procédé selon l'une quelconque des revendications 1 à 5, **caractérisé en ce que**, après la fracture le long de la zone fragilisée, on provoque un détachement au niveau d'une interface de collage au sein de la partie à laquelle la couche mince a été transférée.

7. Procédé selon la revendication 6, **caractérisé en ce que** le détachement est provoqué au niveau d'un interface formé, au sein de l'assemblage, avec une énergie de collage réduite.

8. Procédé selon la revendication 6, **caractérisé en ce que** l'on utilise la partie de l'empilement dont la couche mince a été séparée au sein d'un nouvel empilement après avoir formée une nouvelle zone fragilisée délimitant avec la surface libre libérée par la fracture, une future couche mince.

9. Procédé selon l'une quelconque des revendications 1 à 8, **caractérisé en ce que** la zone fragilisée est formée par implantation ionique.

10. Procédé selon l'une quelconque des revendications 1 à 9, **caractérisé en ce que** le premier matériau est du silicium.

## Claims

1. Method for transferring a thin film from a source substrate, a surface layer of which, extending along a free surface, is made out of a first material, to a target substrate, at least one surface layer of which, extending along a free surface, is made out of a second material having a heat expansion coefficient that is different from that of the first material, wherein:
* within the surface layer of the source substrate, there is formed an embrittled region demarcating, with a free surface, a future thin film.
* the source substrate is joined, by its free surface, to the free surface of the target substrate, within a stack of alternating layers formed out of the first and second materials such that there are, on each side of the interface formed by the joining of said free surfaces placed in close contact, layers of the first and second materials, the cumulated thickness of the layers of the first material situated on a first side of this interface being equal to the cumulated thickness of the layers of this first material situated on the other side of this interface, and the cumulated thickness of the layers of the second material situated on this first side of the interface being equal to the cumulated thickness of the layers of this second material situated on the other side of this interface, the layers having thicknesses at least equal to 50 microns and at least equal to 1000 times the depth at which the embrittled zone is formed,
* there is prompted, by input of at least partly thermal energy, a fracture along the embrittled zones so as to detach the thin film.

2. Method according to claim 1, **characterized in that** said stack is made in such a way that each of the two parts situated on either side of the interface comprises a plane of symmetry parallel to said interface

3. Method according to claim 1 or claim 2, **characterized in that** said stack is formed solely by layers made of either of the first and second materials.

4. Method according to any one of the claims 1 to 3, **characterized in that** one of the parts of the stack comprises a layer of the first material held between two other layers of the second material having appreciably equal thicknesses, in having a thickness appreciably equal to twice the thicknesses of these other layers, while the other one of the parts of the stack comprises a layer of the second material held between two other layers formed out of the first material, having appreciably equal thicknesses, in having a thickness appreciably equal to twice the thicknesses of these other layers.

5. Method according to claim 4, **characterized in that** the first part comprises a double layer of the first material sandwiched between two identical layers of the second material while the other part comprises a double layer of the second material sandwiched between two identical layers of the first material.

6. Method according to any one of the claims 1 to 5, **characterized in that**, after the fracture along the embrittled zone, a detachment is brought about at the level of a bonding interface within the part to which the thin film has been transferred.

7. Method according to claim 6, **characterised in that** the detachment is brought about at an interface formed, within the joining, with a reduced bonding energy.

8. Method according to claim 6, **characterized in that** the part of the stack within which a thin film has been separated is used within a new stack after having formed a new embrittled zone demarcating, with the free surface liberated by the fracture, a future thin film.

9. Method according to any one of the claims 1 to 8, **characterized in that** the embrittled zone is formed by ion implantation.

10. Method according to any one of the claims 1-9, **characterized in that** the first material is silicon.

## Patentansprüche

1. Übertragungsverfahren einer dünnen Schicht von einem Quellsubstrat, von dem eine, eine freie Fläche entlanglaufende oberflächliche Schicht aus einem ersten Material ist, auf ein Zielsubstrat, von dem wenigstens eine, eine freie Fläche entlanglaufende oberflächliche Schicht aus einem zweiten Material ist, das einen unterschiedlichen thermischen Ausdehnungskoeffizient von dem des ersten Materials hat, gemäß dem:
* innerhalb der oberflächlichen Schicht des Quellsubstrats ein mit einer freien Fläche ein eine zukünftige dünne Schicht begrenzender brüchiger Bereich gebildet wird,
* das Quellsubstrat durch seine freie Fläche an der freien Fläche des Zielsubstrats innerhalb einer Stapelung von alternierenden Schichten zusammengebaut wird, die aus dem ersten und zweiten Material derart gebildet werden, dass auf jeder Seite der Schnittstelle, die durch den 2usammenbau der genannten freien, in engen Kontakt gebrachten Flächen gebildet wird, Schichten aus erstem und zweitem Material gebildet werden, wobei die kumulierte Dicke der Schichten des ersten Materials, die sich auf einer ersten Seite dieser Schnittstelle befinden, gleich der kumulierten Dicke der Schichten dieses ersten Materials ist, die sich auf der anderen Seite dieser Schnittstelle befinden und die kumulierte Dicke der Schichten des zweiten Materials, die sich auf dieser ersten Seite der Schnittfläche befinden, gleich der kumulierten Dicke der Schichten dieses zweiten Materials ist, die sich auf der anderen Seite dieser Schnittstelle befinden, wobei die Schichten Dicken aufweisen, die mindestens gleich 50 Mikron und mindestens gleich das 1.000-Fache der Tiefe aufweisen, in der der brüchige Bereich gebildet wird,
* per Energieeintrag wenigstens ein thermischer Teil, ein Bruch entlang des brüchigen Bereichs derart hervorgerufen wird, dass die dünne Schicht abgelöst wird.

2. Verfahren gemäß Anspruch 1, **dadurch gekennzeichnet, dass** die genannte Stapelung aus einem Material derart realisiert wird, dass jedes der zwei Teile, die sich auf jeder Seite der Schnittstelle befinden, einen zu der genannten Schnittstelle parallelen Symmetrieplan umfasst.

3. Verfahren gemäß Anspruch 1 oder Anspruch 2, **dadurch gekennzeichnet, dass** die genannte Stapelung ausschließlich aus Schichten gebildet wird, die aus dem einen oder dem anderen des ersten und des zweiten Materials gebildet wird.

4. Verfahren gemäß Anspruch 1 bis 3, **dadurch gekennzeichnet, dass** einer der Teile der Stapelung eine Schicht des ersten Materials umfasst, das zwischen zwei anderen Schichten des zweiten Materials eingekeilt wird, die deutlich gleiche Dicken aufweisen, wobei eine Dicke deutlich gleich dem Doppelten der Dicken dieser anderen Schichten ist, während der andere Teil der Stapelung eine Schicht des zweiten Materials umfasst, die zwischen zwei anderen Schichten eingekeilt wird, die aus dem ersten Material gebildet werden und deutlich gleiche Dicken haben und eine Dicke haben, die deutlich gleich dem Doppelten der Schichten dieser anderen Schichten sind.

5. Verfahren gemäß Anspruch 4, **dadurch gekennzeichnet, dass** der erste Teil eine doppelte Schicht des ersten Materials umfasst, das zwischen zwei identischen Schichten des zweiten Materials eingekeilt ist, während der andere Teil eine doppelte Schicht des zweiten Materials umfasst, das zwischen zwei identischen Schichten des ersten Materials eingekeilt ist.

6. Verfahren gemäß Anspruch 1 bis 5, **dadurch gekennzeichnet, dass** nach dem Bruch entlang des brüchigen Bereichs ein Ablösen auf der Höhe einer Verklebungsschnittstelle in dem Teil hervorgerufen wird, in den die dünne Schicht übertragen wird.

7. Verfahren gemäß Anspruch 6, **dadurch gekennzeichnet, dass** das Ablösen auf der Höhe einer Schnittstelle hervorgerufen wird, die in der Struktur mit einer reduzierten Verklebungsenergie gebildet wird.

8. Verfahren gemäß Anspruch 6, **dadurch gekennzeichnet, dass** der Teil der Stapelung verwendet wird, dessen dünne Schicht in einer neuen Stapelung getrennt wurde, nachdem ein neuer brüchiger Bereich gebildet wurde, der mit der durch den Bruch freigesetzten freien Fläche eine zukünftige dünne Schicht bildet.

9. Verfahren gemäß Anspruch 1 bis 8, **dadurch gekennzeichnet, dass** der brüchige Bereich per Ionenimplantation gebildet wird.

10. Verfahren gemäß Anspruch 1 bis 9, **dadurch gekennzeichnet, dass** das erste Material Silizium ist.
